# EUROPÄISCHE PATENTSCHRIFT

(11) **EP 2 598 676 B1**
(45) Veröffentlichungstag und Bekanntmachung des Hinweises auf die Patenterteilung: **30.03.2016**
(21) Anmeldenummer: 11746467.7
(22) Anmeldetag: 29.07.2011
(51) Int. Cl.: C25D 5/08, C25D 17/00, C25D 21/12, C23C 18/16

(54) **VORRICHTUNG UND VERFAHREN ZUR ERZEUGUNG GEZIELTER STRÖMUNGS- UND STROMDICHTEMUSTER BEI EINER CHEMISCHEN UND/ODER ELEKTROLYTISCHEN OBERFLÄCHENBEHANDLUNG**
DEVICE AND METHOD FOR PRODUCING TARGETED FLOW AND CURRENT DENSITY PATTERNS IN A CHEMICAL AND/OR ELECTROLYTIC SURFACE TREATMENT
DISPOSITIF ET PROCÉDÉ POUR LA GÉNÉRATION D'UN MODÈLE DE COURANT ET DE DENSITÉ DE COURANT CIBLÉ LORS D'UN TRAITEMENT DE SURFACE CHIMIQUE ET/OU ÉLECTROLYTIQUE

(30) Priorität: 29.07.2010 DE 102010033256
(43) Veröffentlichungstag der Anmeldung: 05.06.2013
(73) Patentinhaber: Fraunhofer-Gesellschaft zur Förderung der angewandten Forschung e.V., 80686 München (DE)
(72) Erfinder: DIETRICH, Lothar, 14542 Werder (DE); SCHMIDT, Ralf, 13051 Berlin (DE); OSTMANN, Andreas, 10585 Berlin (DE)
(74) Vertreter: Pfenning, Meinig & Partner mbB
(86) Internationale Anmeldenummer: PCT/EP2011/003859
(87) Internationale Veröffentlichungsnummer: WO 2012/013362

(56) Entgegenhaltungen:
- WO-A1-03/014424
- US-A1- 2008 251 148

## Beschreibung

Die Erfindung betrifft eine Methode zur Realisierung von lokal definierten Flüssigkeitsströmungen auf näherungsweise planaren Werkstücken zum Zweck eines regelbaren Stofftransportes auf dessen gesamter Oberfläche sowie eine Vorrichtung zur konstruktiven Realisierung der erfindungsgemäßen Methode. Gleichzeitig erlaubt die Erfindung die gezielte Verteilung eines elektrischen Feldes auf einer leitfähigen Substratoberfläche.

Vorrichtung und Verfahren eignen sich insbesondere zur Bearbeitung von strukturierten Halbleitersubstraten, Leiterplatten und Foliensubstraten, aber auch zur ganzflächigen Bearbeitung von planaren metallischen und metallisierten Werkstücken. Auch zur Herstellung großflächiger photoelektrischer Platten für die Solarenergiegewinnung oder großformatiger Bildschirmplatten können Vorrichtung und Verfahren erfindungsgemäß eingesetzt werden.

Bei Oberflächenbehandlungen von Substraten mit flüssigen Medien werden Prozessgeschwindigkeiten maßgeblich durch den Stofftransport mittels Konvektion und Diffusion infolge eines Konzentrationsgefälles bestimmt. Wird zusätzlich von außen ein Potential angelegt, kommt noch die Ionenwanderungsgeschwindigkeit mittels Migration hinzu. In einer vorgegebenen Flüssigkeit stellen daher die An- und Abtransportvorgänge von Reaktionsedukten und -produkten innerhalb der Diffusionsschicht die geschwindigkeitsbestimmenden Schritte dar. Dies trifft auf alle Verfahren zu, bei denen ein ausreichender Flüssigkeitsaustausch an der zu behandelnden Oberfläche der Werkstücke benötigt wird, also sowohl auf additive Metallisierungstechniken als auch auf subtraktive Ätztechniken.

Insbesondere bei mikrostrukturierten Substraten, wie sie in der Leiterplattenfertigung oder in der Halbleiterbearbeitung anzutreffen sind, zeigt sich die Schwierigkeit der Anwendung hoher Anströmungsgeschwindigkeiten und Stromdichten mit gleichmäßiger Verteilung auf jedem mit der Prozesslösung reagierenden Flächenelement. Die Erzielung homogener Strömungs- und Stromeffekte wird mit zunehmender Substratgröße und bei ungleichmäßigen Flächenbelegungen schwieriger.

Aus dem Stand der Technik sind bereits Verfahren und Vorrichtungen zur Erzeugung gleichmäßiger Strömungen bei der Substratbearbeitung bekannt. Die Druckschrift DE 10 2007 026633 B4 beschreibt eine Anströmungsmethode für planare Werkstücke, bei der die Flüssigkeit mittels Düsen gleichmäßig ohne designabhängiges Muster auf die gesamte Oberfläche strömt und die Flüssigkeit nicht lokal zurückgeführt wird, sondern am Werkstückrand abfließt. Zur elektrolytischen Behandlung befindet sich in dieser Vorrichtung zwischen Anströmungskörper und Substrat eine unlösliche gelochte Anode.

In DE 10 2007 026635 A1 ist eine Strömungsmethode für planare Werkstücke beschrieben, welche eine auf der gesamten Oberfläche gleichmäßige Flüssigkeitsbewegung mittels eins paddelartigen Körpers erzeugt, bei der sich keine Anode zwecks galvanischer Beschichtung in diesem System befindet und die ebenfalls keine lokale An- und Rückströmung ermöglicht.

Weiterhin wurde versucht, hohe und vektorgerichtete Strömungsgeschwindigkeiten mittels Gaseinleitung in die Prozesskammer, mittels hoher Fließgeschwindigkeiten innerhalb einer Flüssigkeitssäule, mittels einer sich vor dem Substrat bewegenden Lamellenplatte oder mittels in der Prozesskammer angebrachter Düsengalgen zu erreichen. Die Stromdichteverteilung auf der Substratoberfläche wurde bisher durch Feldblenden und/oder separat regelbare Anodensegmente beeinflusst. Die genannten Vorrichtungen weisen allerdings den Nachteil auf, dass keine kombinierte Aufteilung von Flüssigkeitsströmung und elektrischem Stromfluss auf lokal begrenzte Flächenelemente der Substratoberfläche möglich ist.

Der vorliegenden Erfindung liegt damit die Aufgabe zugrunde, eine Vorrichtung und ein Verfahren zu entwickeln, das die genannten Nachteile vermeidet, mit dem also eine homogene Flüssigkeitsströmung auf allen reagierenden Flächenelementen der Substratoberfläche und gleichzeitig eine gezielte Verteilung eines elektrischen Feldes zwischen dem Substrat und einer Gegenelektrode erzielt werden kann.

Diese Aufgabe wird erfindungsgemäß gelöst durch eine Vorrichtung nach den Merkmalen des Anspruchs 1 und durch ein Verfahren nach den Merkmalen des Anspruchs 7. Vorteilhafte Weiterbildungen werden in den abhängigen Ansprüchen beschrieben.

Eine erfindungsgemäße Vorrichtung zur Erzeugung gezielter Strömungs- und Stromdichtemuster bei einer chemischen und bzw. oder elektrolytischen Oberflächenbehandlung umfasst einen Strömungsverteilerkörper, der in einer fluidischen Prozesslösung eingetaucht ist. Dem Strömungsverteilerkörper gegenüber befindet sich ein in einer geeigneten Halterung befestigtes Substrat, dessen Oberfläche von der Prozesslösung benetzt ist, und im Falle einer elektrolytischen Behandlung ist noch ein Elektrodenkörper vorhanden, der sich vorzugsweise auf einer dem Substrat entgegengesetzten Seite des Strömungsverteilerkörpers befindet und der ebenfalls von der Prozesslösung umspült wird.

Der Strömungsverteilerkörper weist eine Vorder- und eine der Vorderseite gegenüberliegende Rückseite auf, wobei die Vorderseite während der Oberflächenbehandlung dem Substrat zugewandt ist und der Abstand zwischen Vorderseite und der zu bearbeitenden Substratoberfläche über die gesamte Fläche möglichst konstant ist. Der Abstand kann dabei einige Millimeter bis einige Zentimeter betragen. Weiter weist dieser Körper mindestens eine Eintrittsöffnung für die Prozesslösung auf und mindestens einen Flüssigkeitsgang, der an der Vorderseite in mindestens einer Austrittsöffnung oder Düse mündet. Durch diese mindestens eine Austrittsöffnung strömt die gepumpte Prozesslösung mit verhältnismäßig hoher Geschwindigkeit in Richtung des Substrats und führt dort die gewünschte Reaktion durch.

Zur Abführung der Prozesslösung auf die Rückseite des Strömungsverteilerkörpers ist mindestens ein Verbindungsgang, vorzugsweise mehrere Verbindungsgänge vorgesehen, die die Prozessflüssigkeit von der Vorderseite auf die Rückseite des Körpers führen und somit einen Kreislauf der Prozesslösung ermöglichen, indem die Lösung von hier wieder in die Eintrittsöffnung gepumpt werden kann.

Die flächige Verteilung der mindestens einen Austrittsöffnung kann näherungsweise einer Verteilung von auf dem Substrat reagierenden Flächenelemente, welche eine abzubildende Struktur definieren, entsprechen, sodass beispielsweise eine Austrittsöffnung mit einem Flächenelement näherungsweise in Flucht liegt. Der Begriff "näherungsweise" soll sowohl eine Abweichung der Position des Flächenelements der abzubildenden Struktur von der Position der Austrittsöffnung um bis zu einen Durchmesser bzw. eine Breite der Austrittsöffnung umfassen, was auch als lateraler Versatz bezeichnet wird, als auch eine Abweichung einer Größe der Austrittöffnung von einer Größe des die abzubildende Struktur bildenden Flächenelements. In letzterem Fall kann die Austrittsöffnung um bis zu eine Größenordnung größer als das korrespondierende, näherungsweise in Flucht liegende Flächenelement sein. Auch eine Anordnung mehrerer benachbarter Austrittsöffnungen in einem gegenüber der Anordnung der übrigen Austrittsöffnungen verengten Raster, um ein korrespondierendes, näherungsweise in Flucht mit diesen Austrittsöffnungen befindliches größeres Flächenelement des Substrats anzuströmen, soll noch von dem Begriff "näherungsweise" umfasst sein. Durch die gewählte Anordnung wird somit sichergestellt, dass mit ausreichend hoher Strömungsgeschwindigkeit eine homogene Anströmung der zu bearbeitenden Bereiche erreicht wird.

In vorteilhafter Weise entspricht die Anordnung des Verbindungsgangs näherungsweise der auf dem Substrat abzubildenden Struktur, sodass besonders vorzugsweise bei einer Mehrzahl derartiger Gänge die Verbindungsgänge den Austrittsöffnungen benachbart sind. Diese Anordnung bewirkt einen unmittelbaren Rückfluss der Prozesslösung nach der chemischen oder elektrolytischen Reaktion und gleichzeitig eine gezielte Lenkung des elektrischen Feldes auf die reagierenden Flächenbereiche. Der Begriff "näherungsweise" soll hierbei wie bereits vorstehend in Bezug auf die Austrittsöffnung auch für den Verbindungsgang definiert sein.

Bei dem Substrat kann es sich um ein im Wesentlichen plattenförmiges Werkstück zur Herstellung von elektrischen oder elektronischen Bauteilen handeln, welches mechanisch in der Halterung fixiert ist und dessen zu bearbeitende Oberfläche mit der aus dem Strömungsverteilerkörper austretenden Prozessflüssigkeit als Behandlungsmedium angeströmt wird. Das Substrat kann im speziellen Fall eine maskierte oder unmaskierte Leiterplatte, ein Halbleitersubstrat oder ein Foliensubstrat sein, oder aber ein beliebiges metallisches oder metallisiertes Werkstück mit einer näherungsweise planaren Oberfläche. Eine näherungsweise planare Oberfläche soll hierbei derart definiert sein, dass ein Höhenunterschied zwischen Erhebungen und Vertiefungen der Substratoberfläche des plattenförmigen Substrats maximal so groß wie der Abstand zwischen dem Substrat und dem Strömungsverteilerkörper ist.

Der Strömungsverteilerkörper ist vorteilhaft mehrteilig, vorzugsweise zweiteilig, ausgeführt. Hierdurch können einzelne Komponenten des Strömungsverteilerkörpers einfach ausgetauscht werden, sodass unterschiedliche Anströmungen oder Rückströmungen eingestellt werden können.

Ein zwischen der Vorderseite des Strömungsverteilerkörpers und der Substratoberfläche liegender Konvektionsraum ist in vorteilhafter Weise durch eine Kunststoffwandung seitlich begrenzt, um eine gezielte Rückströmung der Prozesslösung durch den Strömungsverteilerkörper zu erzwingen und die Wirkung eines gegebenenfalls im Konvektionsraum anliegenden elektrischen Felds zu bündeln.

Eine vorteilhafte Weiterbildung sieht vor, dass im Fall einer elektrochemischen Oberflächenbehandlung auch ein zwischen der Rückseite des Strömungsverteilerkörpers und der Gegenelektrode liegender, mit der Prozessflüssigkeit gefüllter Raum durch eine weitere Kunststoffumwandung seitlich begrenzt wird, um das elektrische Feld bereits vor dem Durchtritt durch die Verbindungsgänge zu homogenisieren.

Die Austrittsöffnungen können durch Bohrungen in der Vorderseite hergestellt werden und weisen einen Durchmesser bzw. eine Breite im Submillimeterbereich bis in den Millimeterbereich, vorzugsweise von 0,05 mm bis 10 mm auf. Alternativ zu reinen Bohrlöchern können die Austrittsöffnungen auch separat gefertigte Düsen umfassen, welche in das Material der Vorderseite geschraubt oder gesteckt werden.

Die Verbindungsgänge können einen runden, quadratischen oder rechteckigen Querschnitt aufweisen und hinsichtlich ihres Durchmessers bzw. ihrer Breite größer als die Austrittsöffnungen sein. Damit soll erreicht werden, dass die Prozesslösung mit hoher Geschwindigkeit gezielt auf die Substratoberfläche trifft und dort einen hohen Stofftransport in den zu bearbeitenden Flächenbereichen bewirkt, während bedingt durch den größeren Durchmesser in den Verbindungsgängen eine niedrigere Strömungsgeschwindigkeit herrscht. Insbesondere ist auch der in den Verbindungsgängen herrschende Druck sehr viel geringer. Im Grenzfall kann die Breite eines Verbindungsganges in der Größenordnung des Substratmaßes liegen. Es kann auch vorgesehen sein, dass mehrere Verbindungsgänge mit unterschiedlichen Durchmessern oder Breiten existieren, wobei in besonders vorteilhafter Weise der Durchmesser bzw. die Breite im Mittel größer als der Durchmesser oder die Breite der Austrittsöffnung ist.

Der Strömungsverteilerkörper kann vorteilhaft aus Kunststoff bestehen, in besonders vorteilhafter Weise aus Polypropylen, Polyvinylchlorid, Polyethylen, Acrylglas, also Polymethylmethacrylat, Polytetrafluorethylen oder einem anderen Material, das von der Prozesslösung nicht zersetzt wird.

Eine weitere vorteilhafte Weiterbildung sieht vor, dass die Eintrittsöffnung sich außerhalb einer Anströmungs- und/oder Rückströmungszone befindet. Durch eine derartige räumliche Separierung findet keine oder nur eine geringfügige Beeinflussung der einströmenden Prozessflüssigkeit mit der Anströmung oder Rückströmung statt. Somit wird auch eine Verwirbelung verhindert, die die Strömungsgeschwindigkeiten herabsetzt und außerdem im Falle eines anliegenden elektrischen Felds eine partielle Abschottung des elektrischen Felds vermieden, welche durch die Verbindungsgänge hervorgerufen wird.

Ein Gegenelektrodenkörper ist vorteilhafterweise im rückseitigen Bereich des Strömungsverteilerkörpers in mechanischem Kontakt mit dem oder räumlich separiert von dem Strömungsverteilerkörper angebracht, so dass der elektrische Stromfluss zwischen der Gegenelektrode und dem als Elektrode wirkenden Substrat innerhalb der Prozesslösung durch die Verbindungsgänge hindurch erfolgt. Je nach eingesetztem Oberflächenbehandlungsverfahren kann der Elektrodenkörper aus einem in der Prozessflüssigkeit unlöslichen Material wie beispielsweise platiniertem Titan oder anderenfalls aus einem löslichen Material wie beispielsweise dem galvanisch abzuscheidenden Metall bestehen. In der Vorrichtung können Elektrodenkörper nahezu jeder Form eingesetzt werden, die bei der elektrolytischen Oberflächenbehandlung üblich sind, wie beispielsweise geschlossene Platten, gitterartigen Gebilde oder mit Pellets gefüllte Metallkörbe.

Die Anordnung des Gegenelektrodenkörpers und des als Elektrode wirkenden Substrats auf verschiedenen Seiten des Strömungsverteilerkörpers weist den Vorteil auf, eine homogene Feldlinienverteilung eines durch die beiden genannten Elektroden hervorgerufenen elektrischen Feldes entsprechend der Anordnung der mit der Prozesslösung reagierenden Flächenbereiche zu ermöglichen. Die Feldverteilung liegt daher auch in homogener Weise auf der zu behandelnden Substratoberfläche an. Der Strömungsverteilerkörper kann schließlich frei zwischen den genannten Elektroden positioniert werden, sodass die erwünschte Reaktion auf den zu behandelnden Teilen der Substratoberfläche durch die durch den Strömungsverteilerkörper hervorgerufene Anströmung maßgeblich beeinflusst wird.

In einem erfindungsgemäßen Verfahren werden ein Strömungsverteilerkörper mit den zuvor beschriebenen Merkmalen und ein zu bearbeitendes Substrat in ein mit der fluidischen Prozesslösung gefülltes Prozessbecken eingebracht und derart ausgerichtet, dass die mit Austrittsöffnungen versehene Vorderseite planparallel zu der Substratoberfläche steht. Kleinere Abweichungen von bis zu 5° sind dabei tolerierbar.

Falls die Oberflächenbehandlung mit Hilfe einer von außen angelegten Spannung erfolgen soll, wird das Substrat mit einer ersten Elektrode verbunden, sodass Elektrode und Substrat auf dem gleichen Potential liegen. Ein Gegenelektrodenkörper mit zur ersten Elektrode umgekehrter Polarität wird in diesem Fall ebenfalls in die Prozesslösung eingebracht, in den rückseitigen Bereich des Strömungsverteilerkörpers.

Die Prozesslösung wird in die Eintrittsöffnung oder mehrere der Eintrittsöffnungen gepumpt und tritt mit hoher Geschwindigkeit aus der Austrittsöffnung oder den Austrittsöffnungen als Anströmung aus. Da die Austrittsöffnungen vorteilhaft näherungsweise die Struktur der auf dem Substrat herzustellenden Struktur aufweisen, wird besonders an den den Austrittsöffnungen gegenüberliegenden Stellen der Substratoberfläche die gewünschte Reaktion stattfinden. Durch die Verbindungsgänge fließt die Prozesslösung dann als Rückströmung auf die Rückseite des Strömungsverteilerkörpers und kann so in einem Kreislauf gepumpt werden. Der Strömungsverteilerkörper und das Substrat sind somit frei beweglich relativ zueinander, sodass durch eine Veränderung der Position des Strömungsverteilerkörpers die Anströmung auf das Substrat einfach und schnell verändert werden kann.

In einer vorteilhaften Weiterbildung des Verfahrens können zur Vermeidung statischer Flüssigkeitsströmungen auf der Substratoberfläche der Strömungsverteilerkörper und das Substrat eine parallele Relativbewegung zueinander ausführen. Hierzu können entweder nur der Strömungsverteilerkörper oder nur das Substrat, aber natürlich auch beide in linearen Hub-, kreisförmigen Dreh- oder oszillierenden Bewegungen bewegt werden. Hierdurch wird die Anströmung der Prozessflüssigkeit durch die zusätzliche Bewegung unterstützt sowie durch die permanente Bewegung des Strömungsverteilerkörpers eine Dynamik der Anströmung aufrechterhalten. Zudem ist durch die räumliche Separierung des Substrats und des Strömungsverteilerkörpers eine Relativbewegung entlang beliebiger Achsen möglich.

Das Verfahren kann aus der Gruppe der elektrolytischen oder chemischen Oberflächenbehandlungen stammen, und insbesondere eine galvanische Beschichtung, chemisches oder elektrochemisches Ätzen, anodische Oxidation oder ein anderes Verfahren der außenstromlosen Metallabscheidung umfassen.

Ausführungsbeispiele der Erfindung sind in den Figuren 1 bis 3 dargestellt und werden nachfolgend anhand dieser Figuren erläutert.

Es zeigen:
- Fig. 1: eine Seitenansicht einer erfindungsgemäßen Vorrichtung im Querschnitt bei vertikaler Halterung;
- Fig. 2: eine Seitenansicht einer erfindungsgemäßen Vorrichtung im Querschnitt bei horizontaler Halterung und
- Fig. 3: eine perspektivische Ansicht eines Teils eines zweiteiligen Strömungsverteilerkörpers.

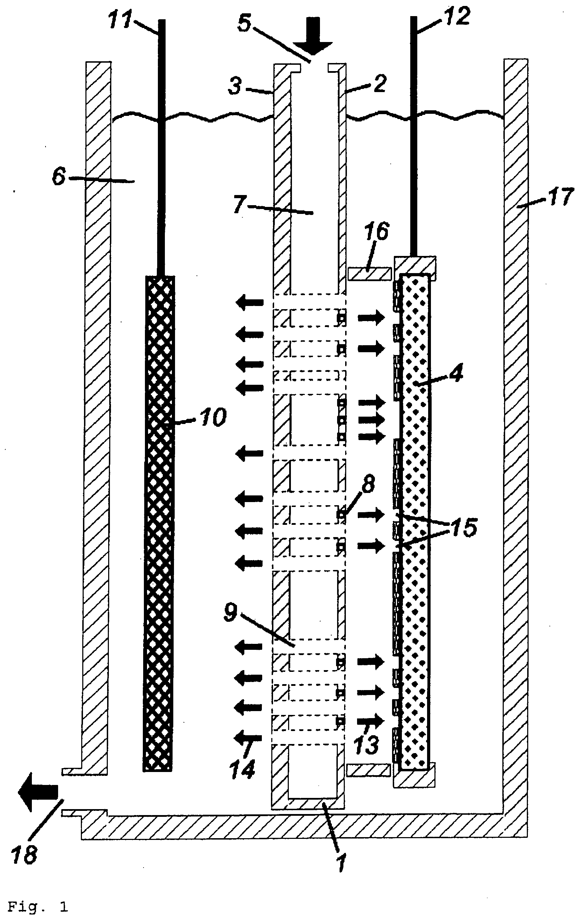

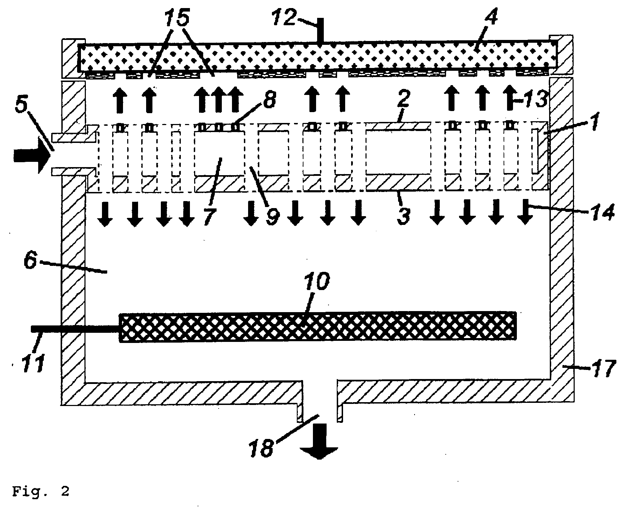

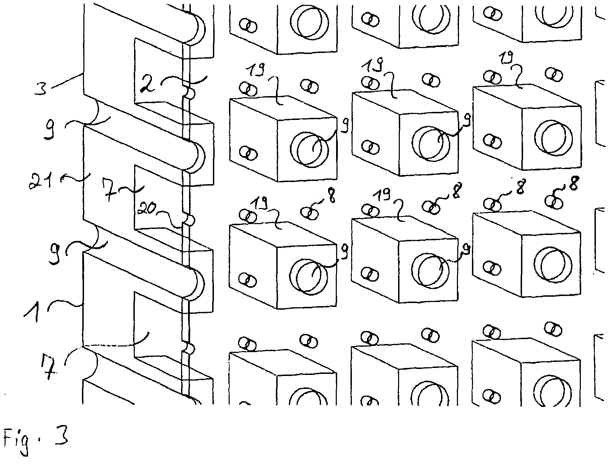

Die Figuren 1 und 2 zeigen im Querschnitt jeweils eine Seitenansicht je eines Ausführungsbeispiels einer erfindungsgemäßen Vorrichtung. Wiederkehrende Merkmale sind in den Fign. 2 und 3 mit gleichen Bezugszeichen wie in Fig. 1 versehen. Ein Strömungsverteilerkörper 1 befindet sich eingetaucht in eine fluidische Prozesslösung 6, die wässrig oder nicht wässrig sein kann, in einem Prozessbecken 17 aus einem Kunststoff, beispielsweise Polypropylen. In diesem Prozessbecken 17 befinden sich außerdem ein Substrat 4 mit einer leitfähigen Oberfläche, welches mit einer Elektrode 12 verbunden ist, sowie ein Gegenelektrodenkörper 10, der mit einer weiteren Elektrode 11, deren Polarität entgegengesetzt derjenigen der Elektrode 12 ist, verbunden ist. Der Gegenelektrodenkörper 10 ist als Platte ausgeführt und weist keine Durchbrüche auf. Der Gegenelektrodenkörper 10, das Substrat 4 und der Strömungsverteilerkörper 1 sind räumlich voneinander separiert, wobei ein Abstand zwischen dem Substrat 4 und dem Strömungsverteilerkörper 1 20 mm beträgt, während der Abstand zwischen dem Strömungsverteilerkörper 1 und der Gegenelektrode 10 40 mm beträgt. Das Substrat 4 ist im vorliegenden Fall ein metallisches Substrat, es kann aber beispielsweise in anderen Ausführungsbeispielen auch ein Halbleitersubstrat, wie ein Wafer, oder eine Leiterplatte verwendet werden. Zum Aufbringen einer Struktur 15 auf Teilflächen des Substrats 4 wurde das Substrat 4 mit einer geeigneten Maskierung versehen, die von der Prozesslösung 6 nicht oder nur schwach angegriffen wird. "Schwach" soll in diesem Zusammenhang bedeuten, dass die Maskierung, beispielsweise ein Photoresist, zwar von der Prozesslösung abgetragen wird, dieser Prozess aber so langsam voranschreitet, dass bei üblichen Prozessdauern ein Rest der Maskierung auf dem Substrat 4 verbleibt.

Die weitere Elektrode 11 ist als Anode ausgebildet, während die Elektrode 12 als Kathode fungiert, selbstverständlich kann in anderen Ausführungsformen aber auch die weitere Elektrode 11 die Kathode darstellen, wenn die Elektrode 12 die Anode ist. Auf dem Substrat 4 wird im dargestellten Ausführungsbeispiel durch eine galvanische Reaktion Metall abgeschieden. Als Prozessflüssigkeit 6 wird eine elektrolytische Flüssigkeit verwendet. Durch die Anordnung des Gegenelektrodenkörpers 10 und des Substrats 4 verläuft das von den beiden Elektroden 11, 12 erzeugte elektrische Feld stets durch den Strömungsverteilerkörper 1 hindurch. Durch eine geeignete Positionierung des Strömungsverteilerkörpers 1 bezüglich des Gegenelektrodenkörpers 10 und des Substrats 4 können somit Bereiche des Substrats 4 sowohl mit einer besonders starken Anströmung 13 als auch mit dem elektrischen Feld beaufschlagt werden, sodass eine Reaktion an diesen Stellen bevorzugt abläuft.

Der Strömungsverteilerkörper 1 weist eine Vorderseite 2 auf, die möglichst planparallel zum Substrat 4 ausgerichtet ist. Kleinere Abweichungen der Parallelität bis ungefähr 5° können allerdings toleriert werden. Gegenüber der Vorderseite 2 befindet sich eine Rückseite 3. Zwischen Vorder- und Rückseite befindet sich ein Hohlraum, der Flüssigkeitsgang 7, in den Prozesslösung 6 gefüllt werden kann. Dazu befindet sich in einem zwischen der Vorderseite 2 und der Rückseite 3 befindlichen seitlichen Bereich des Strömungsverteilerkörpers 1 eine Eintrittsöffnung 5, die zum Anschluss an die Verrohrung des Pumpkreislaufs mit einem Gewinde versehen ist. Der Strömungsverteilungskörper 1 selbst ist aus Polypropylen hergestellt.

Der durch die Vorderseite 2 und die Oberfläche des Substrats 4 gebildete Konvektionsraum wird weiter begrenzt durch die Umwandung des Prozessbeckens 17 und eine weitere Umwandung 16, die eine gezielte Rückströmung 14 durch Verbindungsgänge 9 erzwingt und gleichzeitig die Feldlinienverteilung günstig beeinflusst. Diese Umwandungen sind im dargestellten Ausführungsbeispiel ebenso aus Polypropylen. Ebenso wie die weitere Umwandung 16 zwischen dem Substrat 4 und der Vorderseite 2 angeordnet ist, kann eine derartige Umwandung natürlich auch zwischen der Rückseite 3 und dem Gegenelektrodenkörper 10 angeordnet sein. Die weitere Umwandung 16 ist im dargestellten Beispiel wie das Prozessbecken 17 aus einem Kunststoff wie z. B. Polypropylen.

Im Strömungsverteilerkörper 1 sind Bohrlöcher mit einem Durchmesser von 1 mm enthalten, die in Austrittsöffnungen 8 des Flüssigkeitsgangs 7 mit jeweils identischem Durchmesser auf der Vorderseite 2 münden. Neben zylindrischen Formen können die Bohrlöcher auch eine konische Form aufweisen. Die Verteilung der Austrittsöffnungen 8 entspricht näherungsweise der herzustellenden Struktur 15 auf dem Substrat 4, d. h. die Austrittsöffnungen 8 liegen fluchtend denjenigen Teilflächen des Substrats 4 gegenüber, an denen die Struktur 15 abgebildet werden soll. Somit trifft die Anströmung 13 aus den Austrittsöffnungen 8 kommend direkt auf diejenigen Teilflächen des Substrats 4, die an der elektrochemischen Reaktion teilnehmen sollen. Die Austrittsöffnungen 8 sind rund, können aber auch elliptisch oder rechteckig bzw. in anderen geometrischen Formen ausgestaltet sein, sofern eine ausreichende Strömungsgeschwindigkeit erreicht werden kann. Die Austrittsöffnungen 8 können auch in einer räumlichen Dimension deutlich größer als in der anderen sein, sodass beispielsweise eine zeilen- oder spaltenartige Geometrie erreicht wird, wobei die Zeilen oder Spalten sich über nahezu die ganze Länge bzw. Breite des Strömungsverteilerkörpers 1 erstrecken können.

Die Prozesslösung 6 tritt durch die Austrittsöffnungen 8 aus dem zwischen Vorderseite 2 und Rückseite 3 liegenden Hohlraum mit hoher Strömungsgeschwindigkeit aus und bildet eine auf das Substrat 4 gerichtete Anströmung 13. In den lokalen Flächenbereichen als aufzubringende Struktur 15 findet die Metallabscheidung statt und die Richtung der Strömung kehrt sich dort um. Durch die nun weniger stark gerichtete Strömung sinkt die Strömungsgeschwindigkeit, die sich ausbildende Rückströmung 14 wird durch die Verbindungsgänge 9 zur Rückseite 3 des Strömungsverteilerkörpers 1 geführt. Die Verbindungsgänge 9 liegen benachbart zu den Austrittsöffnungen 8 und bilden somit die auf dem Substrat 4 herzustellende Struktur 15 ebenfalls näherungsweise um ca. 2 mm gegenüber den Flächen der Struktur 15 versetzt ab. Die Verbindungsgänge 9 sind im dargestellten Ausführungsbeispiel einzelne Röhrchen, die in entsprechende Öffnungen des Strömungsverteilerkörpers 1 eingesetzt wurden.

Die Verbindungsgänge 9 weisen einen Durchmesser von 5 mm auf. Bedingt durch die unterschiedlichen Größenverhältnisse von Verbindungsgängen 9 und Austrittsöffnungen 8 sind der Flüssigkeitsdruck und die Strömungsgeschwindigkeit in den Verbindungsgängen 9 sehr viel niedriger. Die auf die Rückseite 3 des Strömungsverteilerkörpers 1 gelangte Prozesslösung 6 wird durch einen Abfluss 18 des Prozessbeckens 17 und eine hier nicht dargestellte Pumpe wieder in die Eintrittsöffnung 5 gepumpt.

Zur Vermeidung von starren Strömungsvektoren und stattdessen einer möglichst gleichmäßigen Konvektion auf den reagierenden Flächenbereichen des Substrats 4 befinden sich der Strömungsverteilerkörper 1 und das Substrat 4 in einer zueinander parallelen Relativbewegung von bis zu 1 mm in beide Richtungen, wobei im vorliegenden Fall beide Körper parallel zu der Anströmung 13 bzw. der Rückströmung 14 bewegt werden.

In Fig. 1 ist eine vertikale Halterung von Strömungsverteilerkörper 1 und Substrat 4 dargestellt, während Fig. 2 eine horizontale Anordnung zeigt. Auch bei der horizontalen Anordnung liegt die Vorderseite 2 des Strömungsverteilerkörpers 1 dem Substrat 4 gegenüber. Der Rückseite 3 des Strömungsverteilerkörpers 1 zugewandt befindet sich der Gegenelektrodenkörper 10. Das Substrat 4 schließt das Prozessbecken 1 deckelartig ab und verhindert ein Austreten der Prozessflüssigkeit 6 aus dem Prozessbecken 1. Die Eintrittsöffnung 5 des Strömungsverteilerkörpers 1 ist in eine Öffnung des Prozessbeckens 17 eingebracht und mit diesem mechanisch stabil verbunden. Durch die entgegen der Schwerkraft erfolgende Anströmung 13 wird in dem in Fig. 2 dargestellten Ausführungsbeispiel die Rückströmung 14 erleichtert, da diese durch die Schwerkraft unterstützt wird. Das Substrat 4 ist wie auch in dem in Fig. 1 gezeigten Ausführungsbeispiel frei bewegbar in Bezug auf den Strömungsverteilerkörper 1, sodass durch Verschieben oder Verdrehen Feldlinienverläufe zwischen dem Gegenelektrodenkörper 10 und dem Substrat 4 frei einstellbar sind.

Es kann aber natürlich auch eine um einen Winkel gegenüber der Umwandung des Prozessbeckens 17 verkippte Halterung vorgesehen sein. Vorderseite 2 und Rückseite 3 des Strömungsverteilerkörpers 1 müssen nicht zwangsläufig, wie in Fig. 1 und Fig. 2 dargestellt, stoffschlüssig miteinander verbunden sein. In einem weiteren, hier allerdings nicht dargestellten Ausführungsbeispiel können als Vorderseite 2 und Rückseite 3 auch zwei Platten mit den entsprechenden Öffnungen verwendet werden, die relativ zueinander positioniert und durch Klemmen oder Schrauben in dieser Position gehalten werden.

In einem weiteren, in Fig. 3 dargestellten Ausführungsbeispiel können die Eintrittsöffnung 5, die Flüssigkeitsgänge 7 und die Verbindungsgänge 9 auch in einen Vollmaterialblock 21, beispielsweise aus Polyvinylchlorid, gefräst sein. In dieser Figur ist in perspektivischer Ansicht ein Teil eines zweiteiligen Strömungsverteilerkörpers 1 dargestellt. Der gefräste Vollmaterialblock 21 bildet die Rückseite 3 des Strömungsverteilerkörpers 1 und umfasst von der Rückseite 3 wegweisende, durch Fräsen erzeugte, quaderförmige Stege 19, die in einem Abstand von 2 mm periodisch angeordnet sind und mittig jeweils einen der durch die Stege 19 hindurchlaufenden Verbindungsgänge 9 aufweisen. Zwischen den Stegen 19 befinden sich die Flüssigkeitsgänge 7.

Eine zusätzliche Platte 20 bildet die Vorderseite 2. Diese zusätzliche Platte 20 ist formschlüssig auf dem gefrästen Vollmaterialblock 21 angeordnet und an diesem beispielsweise durch eine Schraub- oder eine Klemmverbindung befestigt. Hierzu liegt die zusätzliche Platte 20 auf einer zu der Rückseite 3 parallelen, quadratischen Oberfläche der Stege 19 auf. In der gewählten Darstellung der Fig. 3 ist die zusätzliche Platte 20 aus Polymethylmethacrylat und transparent. Die zusätzliche Platte 20 weist ebenfalls Öffnungen für die Verbindungsgänge 9 auf, die mit den Verbindungsgängen 9 des gefrästen Vollmaterialblocks 21 in Deckung gebracht wurden. Außerdem weist die zusätzliche Platte 20 Austrittsöffnungen 8 auf, deren Durchmesser mit 0,2 mm kleiner als der Durchmesser der Verbindungsgänge 9 mit 0,6 mm ist, welche jedoch ebenfalls periodisch mit einem Abstand von 1 mm auf der zusätzlichen Platte 20 angeordnet sind.

Die linke Seite des zweiteiligen, aus zusätzlicher Platte 20 und gefrästem Vollmaterialkörper 21 bestehenden Strömungsverteilerkörpers 1 ist in Schnittdarstellung wiedergegeben, um zu verdeutlichen, dass die Verbindungsgänge 9 komplett durch die Stege 19 hindurch verlaufen.

In den zwischen der zusätzlichen Platte 20 und dem gefrästen Vollmaterialblock 21 befindlichen Flüssigkeitsgang 7, welcher die Höhe der Stege 19 hat, wird durch eine oder mehrere, in Fig. 3 nicht dargestellte Eintrittsöffnungen 5 die Prozessflüssigkeit 6 eingebracht, welche nur durch die Austrittsöffnungen 8 den Strömungsverteilerkörper 1 auf der Vorderseite 2 als Anströmung 13 verlassen kann und durch die Verbindungsgänge 9 von der Vorderseite 2 auf die Rückseite 3 als Rückströmung 14 geführt wird. Um der Anströmung 13 eine andere Geometrie zu geben, kann die zusätzliche Platte 20 gegen eine andere Platte ausgetauscht werden, bei der die Öffnungen für die Verbindungsgänge 9 zwar positionsgleich mit den in Fig. 3 gezeigten sind, die Austrittsöffnungen 8 jedoch eine andere Position aufweisen.

Lediglich in den Ausführungsbeispielen offenbarte Merkmale der verschiedenen Ausführungsformen können miteinander kombiniert und einzeln beansprucht werden.

## Patentansprüche

1. Vorrichtung zur Erzeugung gezielter Strömungs- und Stromdichtemuster bei einer chemischen und/oder elektrolytischen Oberflächenbehandlung eines Substrats (4) in einer fluidischen Prozesslösung (6),
**dadurch gekennzeichnet, dass**
die Vorrichtung einen Strömungsverteilerkörper (1) mit einer während der Oberflächenbehandlung dem Substrat (4) zugewandten Vorderseite (2) und einer der Vorderseite (2) gegenüberliegenden Rückseite (3) umfasst,
wobei der Strömungsverteilerkörper (1) mindestens eine Eintrittsöffnung (5) für die Prozesslösung (6) und mindestens einen Flüssigkeitsgang (7) umfasst,
wobei der mindestens eine Flüssigkeitsgang (7) an der Vorderseite (2) mindestens eine Austrittsöffnung (8) zur Erzeugung einer Anströmung (13) auf dem Substrat (4) aufweist
und wobei der Strömungsverteilerkörper (1) mindestens einen Verbindungsgang (9) zur Aufnahme einer Rückströmung (14) von dem Substrat (4) aufweist, der von der Vorderseite (2) zur Rückseite (3) verläuft.

2. Vorrichtung nach Anspruch 1, **dadurch gekennzeichnet, dass** die Anordnung der mindestens einen Austrittsöffnung (8) auf der Vorderseite (2) näherungsweise einer auf dem Substrat (4) abzubildenden Struktur (15) entspricht.

3. Vorrichtung nach Anspruch 1 oder 2, **dadurch gekennzeichnet, dass** die Anordnung des mindestens einen Verbindungsgangs (9) auf der Vorderseite (2) näherungsweise der auf dem Substrat (4) abzubildenden Struktur (15) entspricht.

4. Vorrichtung nach einem der vorhergehenden Ansprüche, **dadurch gekennzeichnet, dass** die mindestens eine Austrittsöffnung (8) einen Durchmesser bzw. eine Breite zwischen 0,05 mm und 10 mm aufweist.

5. Vorrichtung nach einem der vorhergehenden Ansprüche, **dadurch gekennzeichnet, dass** der mindestens eine Verbindungsgang (9) einen größeren Durchmesser bzw. eine größere Breite als die mindestens eine Austrittsöffnung (8) aufweist, wobei der Durchmesser bzw. die Breite ein Maß bis hin zur Substratgröße erreichen kann.

6. Vorrichtung nach einem der vorhergehenden Ansprüche, **dadurch gekennzeichnet, dass** die Eintrittsöffnung (5) sich außerhalb einer Anströmungszone (13) und/oder Rückströmungszone (14) befindet.

7. Verfahren zur Erzeugung gezielter Strömungs- und Stromdichtemuster bei einer chemischen und/oder elektrolytischen Oberflächenbehandlung eines Substrats (4) in einer fluidischen Prozesslösung (6), umfassend die folgenden Schritte:
a) Einbringen eines Strömungsverteilerkörpers (1) mit mindestens einem Flüssigkeitsgang (7) in die fluidische Prozesslösung (6);
b) Ausrichten des Strömungsverteilerkörpers (1) derart, dass seine Vorderseite (2) planparallel zu dem zu bearbeitenden Substrat (4) steht;
c) Pumpen der Prozesslösung (6) durch mindestens eine Eintrittsöffnung (5) derart, dass die Prozesslösung (6) durch mindestens eine Austrittsöffnung (8) als Anströmung (13) auf das Substrat (4) trifft und als Rückströmung (14) durch mindestens einen Verbindungsgang (9) abfließt.

8. Verfahren nach Anspruch 7, **dadurch gekennzeichnet, dass** das Substrat (4) mit einer ersten Elektrode (11) verbunden ist, wobei in der Prozesslösung (6) ein Gegenelektrodenkörper (10) enthalten ist, der mit einer zweiten Elektrode (12) mit zur ersten Elektrode (11) umgekehrter Polarität verbunden ist.

9. Verfahren nach Anspruch 7 oder 8, **dadurch gekennzeichnet, dass** während des Pumpens der Prozesslösung (6) der Strömungsverteilerkörper (1) und/oder das Substrat (4) eine parallel zueinander gerichtete Relativbewegung ausführen.

10. Verfahren nach einem der vorhergehenden Ansprüche, **dadurch gekennzeichnet, dass** das Substrat (4) eine Leiterplatte, ein Halbleitersubstrat, ein Foliensubstrat oder aber ein im Wesentlichen plattenförmiges metallisches ober metallisiertes Werkstück umfasst und dessen zu bearbeitende Oberfläche maskiert oder unmaskiert ist.

11. Verfahren nach einem der vorhergehenden Ansprüche, **dadurch gekennzeichnet, dass** eine galvanische Beschichtung, chemisches oder elektrochemisches Ätzen, anodische Oxidation oder ein anderes Verfahren der außenstromlosen Metallabscheidung vorgenommen wird.

## Claims

1. A device for creating targeted flow and current density patterns in a chemical and/or electrolytic surface treatment of a substrate (4) in a fluidic process solution (6),
**characterized in that**
the device comprises a flow distributor body (1) having a front face (2) facing the substrate (4) during the surface treatment, and a rear face (3) opposite of the front face (2),
wherein the flow distributor body (1) comprises at least one inlet opening (5) for the process solution (6), and at least one liquid passage (7),
wherein the at least one liquid passage (7) has at least one outlet opening (8) at the front face (2) for creating an incoming flow (13) on the substrate (4),
and wherein the flow distributor body (1) has at least one connecting passage (9) for receiving a backflow (14) from the substrate (4), which extends from the front face (2) to the rear face (3).

2. The device according to claim 1, **characterized in that** the arrangement of the at least one outlet opening (8) on the front face (2) corresponds approximately to a structure (15) to be displayed on the substrate (4).

3. The device according to claims 1 or 2, **characterized in that** the arrangement of the at least one connecting passage (9) on the front face (2) corresponds approximately to the structure (15) to be displayed on the substrate (4).

4. The device according to one of the previous claims, **characterized in that** the at least one outlet opening (8) has a diameter, or a width, respectively, of between 0.05 mm and 10 mm.

5. The device according to one of the previous claims, **characterized in that** the at least one connecting passage (9) has a larger diameter, or a larger width, respectively, than the at least one outlet opening (8), wherein the diameter, or the width, respectively, may reach a dimension up to the substrate size.

6. The device according to one of the previous claims, **characterized in that** the inlet opening (5) is located outside of an incoming flow zone (13) and/or backflow zone (14).

7. A method for creating targeted flow and current density patterns in a chemical and/or electrolytic surface treatment of a substrate (4) in a fluidic process solution (6), comprising the following steps:
a) inserting a flow distributor body (1) with at least one liquid passage (7) into the fluidic process solution (6);
b) aligning the flow distributor body (1) such that its front face (2) is positioned plane-parallel to the substrate (4) to be treated;
c) pumping the process solution (6) through at least one inlet opening (5) such that the process solution (6) impinges upon the substrate (4) as an incoming flow (13) through the at least one outlet opening (8), and flows off as a backflow (14) through at least one connecting passage (9).

8. The method according to claim 7, **characterized in that** the substrate (4) is connected to a first electrode (11), wherein a counter electrode body (10) is contained in the process solution, which is connected to a second electrode (12) having a polarity that is reverse to that of the first electrode (11).

9. The method according to claims 7 or 8, **characterized in that** the flow distributor body (1), and/or the substrate (4) perform a relative movement directed parallel to each other during the pumping of the process solution (6).

10. The method according to one of the previous claims, **characterized in that** the substrate (4) comprises a conductor plate, a semi-conductor substrate, a film substrate, or an essentially plate-shaped, metal or metallized workpiece, and that the surface to be treated is masked or unmasked.

11. The method according to one of the previous claims, **characterized in that** a galvanized coating, chemical or electrochemical etching, anodal oxidation, or another method of the external currentless metal separation is performed.

## Revendications

1. Dispositif de production d'un modèle d'écoulement et de densité de flux lors d'un traitement de surface chimique et/ou électrolytique d'un substrat (4) dans une solution de traitement fluide (6)
**caractérisé en ce que**
le dispositif comprend un élément répartiteur d'écoulement (1) avec un côté avant (2) orienté vers le substrat (4) pendant le traitement de surface et un côté arrière (3) opposé au côté avant (2),
l'élément répartiteur d'écoulement (1) comprenant au moins une ouverture d'entrée (5) pour la solution de traitement (6) et au moins un passage de liquide (7),
l'au moins un passage de liquide (7) comprend, sur le côté avant (2), au moins une ouverture de sortie (8) pour la production d'un écoulement (13) sur le substrat (4)
et l'élément répartiteur d'écoulement (1) comprenant au moins un passage de liaison (9) pour le logement d'un écoulement de retour (14) à partir du substrat (4), qui va du côté avant (2) au côté arrière (3).

2. Dispositif selon la revendication 1, **caractérisé en ce que** la disposition de l'au moins une ouverture de sortie (8) sur le côté avant (2) correspond approximativement à une structure (15) à former sur le substrat (4).

3. Dispositif selon la revendication 1 ou 2, **caractérisé en ce que** la disposition de l'au moins un passage de liaison (9) sur le côté avant (2) correspond approximativement à la structure (15) à former sur le substrat (4).

4. Dispositif selon l'une des revendications précédentes, **caractérisé en ce que** l'au moins une ouverture de sortie (8) présente un diamètre ou une largeur entre 0,05 mm et 10 mm.

5. Dispositif selon l'une des revendications précédentes, **caractérisé en ce que** l'au moins un passage de liaison (9) présente un diamètre ou une largeur supérieure à l'au moins une ouverture de sortie (8), le diamètre ou la largeur peut atteindre une taille pouvant aller jusqu'à la taille du substrat.

6. Dispositif selon l'une des revendications précédentes, **caractérisé en ce que** l'ouverture d'entrée (5) se trouve à l'extérieur d'une zone d'écoulement (13) et/ou d'une zone d'écoulement de retour (14).

7. Procédé de production d'un modèle d'écoulement et de densité de flux lors d'un traitement de surface chimique et/ou électrolytique d'un substrat (4) dans une solution de traitement fluide (6), comprenant les étapes suivantes :
a) insertion d'un élément répartiteur d'écoulement (1) avec au moins un passage de liquide (7) dans la solution de traitement fluide (6) ;
b) orientation de l'élément répartiteur d'écoulement (1) de façon à ce que son côté avant (2) soit parallèle au substrat (4) à traiter ;
c) pompage de la solution de traitement (6) à travers au moins une ouverture d'entrée (5), de façon à ce que la solution de traitement (6) passe à travers au moins une ouverture de sortie (8) sous la forme d'un écoulement (13) sur le substrat (4) et s'écoule, sous la forme d'un écoulement de retour (14) à travers au moins un passage de liaison (9).

8. Procédé selon la revendication 7, **caractérisé en ce que** le substrat (4) est relié avec une première électrode (11), un élément de contre-électrode (10) étant contenu dans la solution de traitement (6), qui est relié avec une deuxième électrode (12) avec une polarité inversée par rapport à la première électrode (11).

9. Procédé selon la revendication 7 ou 8, **caractérisé en ce que**, pendant le pompage de la solution de traitement (6), l'élément répartiteur d'écoulement (1) et/ou le substrat (4) effectuent des mouvements relatifs parallèles entre eux.

10. Procédé selon l'une des revendications précédentes, **caractérisé en ce que** le substrat (4) comprend un circuit imprimé, un substrat de semi-conducteur, un substrat sous forme de film ou une pièce métallique ou métallisée en forme de plaque et dont la surface à traiter est masquée ou non masquée.

11. Procédé selon l'une des revendications précédentes, **caractérisé en ce qu'**un revêtement galvanique, une gravure chimique ou électrochimique, une oxydation anodique ou un autre procédé de dépôt métallique sans courant extérieur est employé.
